Europäisches Patentamt

European Patent Office

Office européen des brevets

(19)

(11) Numéro de publication : **0 611 452 B1**

## (12) FASCICULE DE BREVET EUROPEEN

(45) Date de publication du fascicule du brevet :
27.09.95 Bulletin 95/39

(21) Numéro de dépôt : **93900225.9**

(22) Date de dépôt : **05.11.92**

(86) Numéro de dépôt international :
**PCT/FR92/01030**

(87) Numéro de publication internationale :
**WO 93/09445 13.05.93 Gazette 93/12**

(51) Int. Cl.⁶ : $G01R\ 31/36$

---

54 DISPOSITIF ET PROCEDE DE MESURE DE L'ETAT DE CHARGE D'UN ACCUMULATEUR NICKEL-CADMIUM.

(30) Priorité : **08.11.91 FR 9113790**

(43) Date de publication de la demande :
**24.08.94 Bulletin 94/34**

(45) Mention de la délivrance du brevet :
**27.09.95 Bulletin 95/39**

(84) Etats contractants désignés :
**DE ES GB IT SE**

(56) Documents cités :
**EP-A- 0 146 093
DE-A- 2 832 705
US-A- 3 562 634
US-A- 4 189 778**

(56) Documents cités :
**REVUE GENERALE DE L'ELECTRICITE, no. 3, Mars 1990, PARIS FR, pages 50 - 53, ALZIEUET AL. 'UN PARAMETRE DE CONTROLE DE L ETAT D UNE BATTERIE...'**

(73) Titulaire : **UNIVERSITE PARIS-VAL DE MARNE
61, avenue du Géneral-de-Gaulle
F-94010 Créteil Cédex (FR)**

(72) Inventeur : **BOUNAGA, Abdennebi
1, rue Jules-Vallès
F-91011 Evry (FR)**

(74) Mandataire : **Hud, Robert
Cabinet COLLIGNON
15 rue de Surène
F-75008 Paris (FR)**

EP 0 611 452 B1

**Description**

La présente invention concerne un procédé de mesure permettant la détermination de l'état de charge d'un accumulateur Nickel-Cadmium et un dispositif mettant en oeuvre ce procédé.

L'état de charge d'un accumulateur, grandeur désignée par s, est le rapport exprimé en % entre la capacité résiduelle (quantité d'électricité encore disponible dans l'accumulateur à un instant donné) et la capacité totale ou nominale que peut délivrer l'accumulateur au bout de 5 heures (ou 10 ou 20 heures selon le constructeur) lorsqu'il est déchargé à son régime nominal à partir d'un état de pleine charge. La connaissance de l'état de charge S permet d'une part d'optimiser la durée de vie des accumulateurs en limitant la profondeur de décharge ou de charge à la fin de chaque cycle, et, d'autre part, d'avoir un meilleur contrôle de l'énergie disponible à un instant donné pour les appareils fonctionnant sur batteries.

Les premières méthodes qui ont été utilisées pour avoir une indication de l'état de charge d'un accumulateur consistent à prendre comme grandeur représentative de S, la tension aux bornes de l'accumulateur à un instant donné en cours de décharge. Cependant, dans le cas d'un accumulateur Nickel-Cadmium, cette tension reste pratiquement constante depuis la charge complète jusqu'à une décharge profonde, et ceci est d'autant plus vrai que le courant de décharge est faible. L'utilisation de cette tension comme indicateur de l'état de charge S s'est avérée par conséquent peu précise. Une autre variante de cette méthode est présentée dans le brevet US 4644245, février 1987 et consiste à faire débiter l'accumulateur Nickel-Cadmium testé avec un fort courant de décharge (50 à 80 A) pendant un temps très court de l'ordre d'une milliseconde et à mesurer la tension aux bornes de l'accumulateur au bout de ce laps de temps. La valeur de la tension ainsi obtenue varie sensiblement avec la capacité résiduelle et est utilisée comme indicateur de l'état de charge de l'accumulateur Nickel-Cadmium testé.

Un autre procédé faisant partie des méthodes stationnaires est présenté dans le brevet européen 67589, décembre 1982 et consiste à utiliser comme grandeur représentative de l'état de charge la caractéristique tension-courant de l'accumulateur en la comparant aux caractéristique s tension-courant obtenues préalablement à différents états de charge sur un accumulateur de même type que l'accumulateur testé; cependant, la caractéristique tension-courant dépend de la valeur de la résistance série intérieure de l'accumulateur qui est une grandeur purement ohmique et qui peut varier d'un échantillon à l'autre.

Dans la catégorie des méthodes non stationnaires, il existe un certain nombre de procédés qui utilisent comme grandeur représentative de l'état de charge d'une pile ou d'un accumulateur la valeur de son impédance complexe mesurée à des fréquences déterminées en circuit ouvert. Par exemple, le procédé selon le brevet FR 2556475, décembre 1987 utilise comme grandeur représentative de l'état de charge d'une pile, l'argument $(a_{12})$ de la différence $(Z_{12})$ entre deux impédances internes $(Z_1)$ et $(Z_2)$ de la pile mesurées à deux fréquences différentes $(f_1)$ et $(f_2)$. Ce procédé présente l'avantage d'écarter l'influence de la résistance série intérieure qui peut introduire des dispersions indésirables d'une pile à une autre. Cependant, les mesures des impédances internes sont réalisées dans des conditions telles que la pile ne débite pas de courant continu, ce qui nécessite que la tension entre les bornes de la pile testée doit rester stable durant les mesures; or, dans le cas d'un accumulateur Nickel-Cadmium qui vient d'être déchargé, il s'écoule généralement un temps de quelques heures avant que la tension entre ses bornes ne se stabilise comme le montre l'article de M.Durga Prasad et al. intitulé "Open circuit voltage recovery of discharged and shorted Nickel-Cadmium cells", J. of appl. Electrochem., 17(1987), pp 463-472.

Un autre procédé non stationnaire est décrit dans le brevet US -A- 3 562 634, Fevrier 1971. Selon ce document, l'état de charge est déterminé par la mesure de la capacité équivalente à une fréquence fixe et par comparaison avec la caractéristique de référence établie à la même fréquence. Or la capacité équivalente dépend aussi de la fréquence de mesure, ce qui oblige donc d'établir une caractéristique de référence pour chaque fréquence. Un autre procédé qui est décrit dans le brevet US-A-4 189 778, Fevrier 1980, utilise une méthode de corrélation statistique. Le principe de cette méthode consiste à faire plusieurs mesures de l'impédance à différentes fréquences sur l'accumulateur testé, et de chercher la corrélation optimale entre ces mesures et les différentes valeurs mesurées dans différentes conditions et stockées en mémoire. Cette méthode assez lourde necessite donc de disposer préalablement d'un nombre considérable de données pour les comparer ensuite aux valeurs mesurées pendant le test. On peut donc dégager plusieurs inconvénients majeurs qui peuvent se présenter simultanément ou non selon le procédé, le premier inconvénient concerne l'influence de la résistance ohmique interne qui introduit des dispersions dans les mesures lorsqu'on passe d'un échantillon (accumulateur ou pile) à un autre; le deuxième inconvénient est la nécessité de faire des mesures en circuit ouvert, ce qui oblige d'attendre que la tension aux bornes de l'accumulateur ou de la pile se stabilise avant de procéder au test. Enfin, Le troisième inconvénient est l'obligation de disposer en mémoire d'un nombre important de valeurs de l'impédance mesurées à différentes conditions pour pouvoir accéder à l'état de charge par des calculs plus ou moins lourds.

L'objet principal de la présente invention est de fournir un procédé de détermination de l'état de charge d'un accumulateur Nickel-Cadmium ne présentant pas les deux inconvénients cités ci-dessus. Le procédé selon la présente invention consiste à faire débiter l'accumulateur testé avec un courant de décharge I constant et à mesurer la partie imaginaire $Z_I$ de son impédance complexe à une fréquence fixe f en cours de décharge. La partie imaginaire ainsi mesurée à la fréquence f et sous le courant de décharge I est utilisée par la suite dans une corrélation qui permet la détermination de l'état de charge de l'accumulateur sous le régime I en question. L'invention a encore pour objet de fournir un dispositif permettant la mise en oeuvre de ce procédé.

Un avantage du procédé selon la présente invention est que la partie imaginaire de l'impédance utilisée comme grandeur permettant d'accéder à l'état de charge de l'accumulateur sous courant de décharge est une grandeur qui ne dépend pas de la résistance série (résistance purement ohmique) de l'accumulateur ce qui minimise donc avantageusement les dispersions dans les mesures lorsque l'on passe d'un échantillon (accumulateur) à un autre. Un autre avantage atteint par le procédé selon la présente invention est la possibilité de faire une évaluation rapide de l'état de charge de l'accumulateur en cours de décharge sans être obligé d'attendre que la tension entre ses bornes se stabilise comme dans le cas des procédés qui utilisent la mesure de l'impédance en circuit ouvert.

La figure 1 du dessin annexé présente la perturbation en courant appliquée à l'accumulateur et la réponse en tension de l'accumulateur à cette perturbation.

La figure 2 montre l'évolution de la partie imaginaire de l'impédance en fonction de l'état de charge à 10.3 Hz et à 14.3 Hz.

La figure 3 montre la relation linéaire qui existe entre l'état de charge et une grandeur $\Gamma$ indépendante de la fréquence et qui sera définie par la suite.

La figure 4 présente le dispositif de mesure de l'état de charge.

La figure 5 présente le schéma bloc détaillé du dispositif de mesure de l'état de charge.

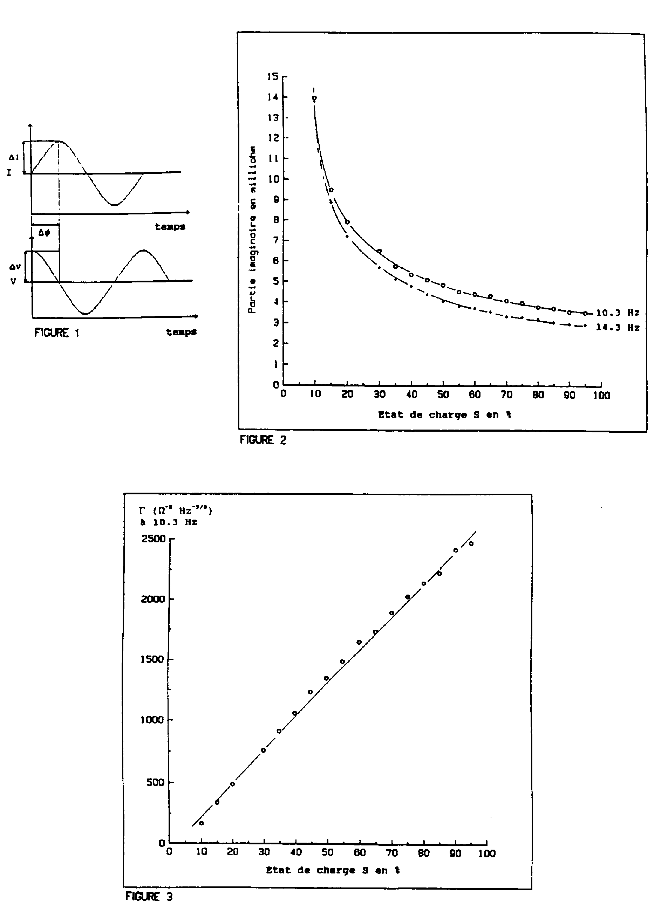

Lorsqu'un accumulateur se décharge à un courant I et lorsque l'on superpose à ce courant une perturbation sinusoidale en courant de faible amplitude $\Delta I$ et de fréquence f, la tension aux bornes de l'accumulateur initialemement égale à V (composante continue) présente alors une variation sinusoidale d'amplitude $\Delta V$ et de même fréquence f que la perturbation appliquée comme le montre la figure 1 sur le dessin annexé. Sur la même figure est représenté le déphasage $\Delta\phi$ entre la tension aux bornes de l'accumulateur et le courant de décharge. L'impédance complexe Z de l'accumulateur sous courant de décharge s'obtient en mesurant les grandeurs $\Delta I$, $\Delta V$ et $\Delta\phi$ et en utilisant la formule

$$Z = (\Delta V/\Delta I) \cos(\Delta\phi) + j (\Delta V/\Delta I) \sin(\Delta\phi)$$

j est un nombre complexe pur. L'impédance Z se décompose en deux parties: une partie réelle résistive $Z_R = (\Delta V/\Delta I) \cos(\Delta\phi)$ incluant la résistance série intérieure de l'accumulateur et une partie imaginaire dite réactive $Z_I = (\Delta V/\Delta I) \sin(\Delta\phi)$ englobant les phénomènes capacitifs. La figure 2 sur le dessin annexé montre la variation en fonction de l'état de charge de la partie imaginaire $Z_I$ mesurée selon le procédé de la présente invention à deux fréquences différentes f=10.3 Hz et f=14.3 Hz en déchargeant un accumulateur Nickel-Cadmium commercial de capacité nominale égale à 1.2 Ah à un régime de 300 mA. Sur cette figure on peut constater que la partie imaginaire $Z_I$ de l'impédance montre une variation importante pour des états de charge inférieurs à 50% et une variation moins importante pour des états de charge supérieurs à 50% . Avantageusement, le procédé selon la présente invention fournit une grandeur représentative de l'état de charge, désignée par $\Gamma$ et calculée en fonction de la partie imaginaire $Z_I$ de l'impédance par la formule $\Gamma = Z_I^{-2} f^{-3/2}$, cette grandeur varie pratiquement linéairement avec l'état de charge de l'accumulateur sous courant de décharge. A titre d'exemple, la figure 3 sur le dessin annexé montre la variation de $\Gamma$ à 10.3 Hz en fonction de l'état de charge du même accumulateur Nickel-Cadmium commercial de capacité nominale égale à 1.2 Ah en cours de décharge à un régime de 300 mA. La validité du procédé selon l'invention, quelle que soit la capacité nominale ou la provenance commerciale de l'accumulateur Nickel-Cadmium, est assurée par le réglage de trois paramètres:

- le courant de décharge en fonction de la capacité nominale de l'accumulateur;
- la fréquence du signal perturbateur en fonction de la capacité nominale et du courant de décharge;
- la valeur de la perturbation $\Delta I$ appliquée en fonction du courant de décharge.

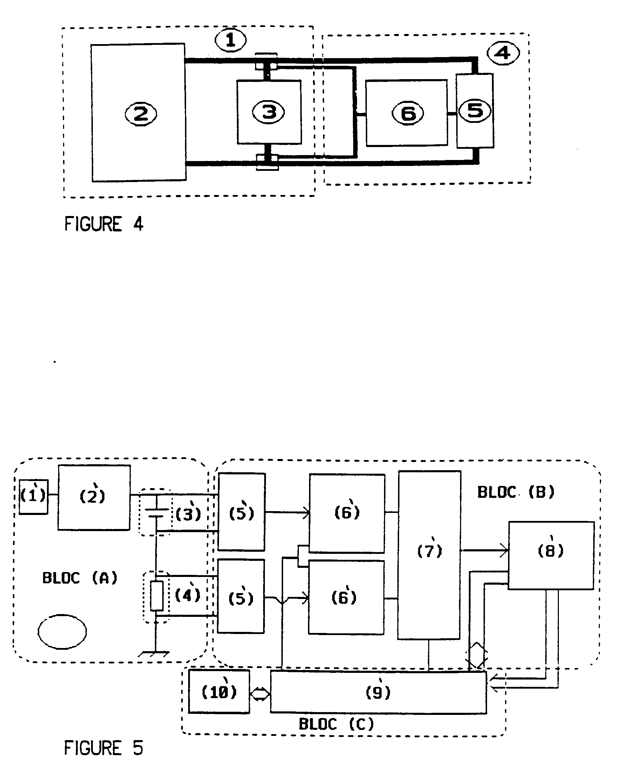

Le dispositif mettant en oeuvre le procédé selon la présente invention réalise une évaluation rapide et précise de l'état de charge des accumulateurs Nickel-Cadmium; la spécificité résidant dans le fait que le dispositif utilise la mesure de l'impédance complexe de ces accumulateurs sous courant de décharge. Par référence à la figure 4, le dispositif 4 réalise le test en faisant débiter l'accumulateur 3 du système 1 ( appareil 2 alimenté par 3 ) dans un circuit secondaire 5 pendant une courte durée. La partie contrôle-commande 6 du dispositif superpose une perturbation en courant de faible amplitude au courant de décharge. La fréquence du signal perturbateur est choisie en fonction de la capacité et du courant de décharge de l'accumulateur. Le traitement par 6 de la réponse en fréquence de l'accumulateur à cette perturbation permet d'accéder à la valeur de l'impédance complexe de l'accumulateur à cette fréquence. La valeur de la partie imaginaire de l'impédance ainsi mesurée ou avantageusement la valeur de la grandeur Γ définie précédemment permet alors d'accéder à l'état de charge de l'accumulateur.

Une réalisation du dispositif est illustrée par le schéma bloc de la figure 5. Le dispositif comprend trois blocs notés (A), (B) et (C).

Le bloc (A) réalisé de façon classique, permet la régulation d'un courant de décharge constant en lui superposant une perturbation en courant de faible amplitude. Ce bloc comprend un générateur de signaux (1'), un circuit intensiostatique (2') permettant de réguler un courant de décharge, l'accumulateur Nickel-Cadmium testé (3') et une résistance étalon (4') pour la mesure du courant. Le circuit intensiostatique (2') peut être remplacé par l'appareil utilisateur fonctionnant sur l'accumulateur de telle sorte que le courant de décharge est fixé par l'appareil utilisateur lui même.

Le bloc (B) constitue le système de mesure et de conversion analogique numérique; il comprend (5') un circuit de conditionnement des signaux permettant l'élimination des composantes continues I et V et l'amplification nécessaire à l'entrée des échantillonneurs-bloqueurs (6'). Le multiplexage des deux signaux mis en forme est réalisé par (7') avant leur conversion analogique-numérique par le convertisseur (8'). Selon une autre variante non illustrée, les moyens (6') et (7') du bloc (B) peuvent être remplacés par un seul composant électronique (exemple le AD 630) permettant d'avoir une sortie proportionnelle à la partie imaginaire de l'impédance à partir des deux signaux d'entrée (courant et tension).

Le bloc (C) de contrôle et de commande effectue le séquencement nécessaire du bloc (B) par l'action du processeur (9'), dont le programme est logé en mémoire interne et externe (10'); ce processeur prend aussi en charge les signaux traités et numérisés afin d'extraire la valeur de l'état de charge par comparaison à des caractéristiques stockées en mémoire (10').

Selon une variante non illustrée, la fonction du bloc (C) peut être remplacée par un moyen de calcul et de contrôle externe convenablement programmé comme un microordinateur par exemple; une liaison informatique classique parallèle ou série réalisant la liaison avec le bloc (B).

Une autre variante, lorsque l'appareil utilisateur de l'accumulateur possède les fonctions de calcul et de contrôle nécessaire, consiste à intégrer les trois blocs dans le système; cette disposition permettant une automatisation de la vérification de l'état de charge.

**Revendications**

1. Procédé de mesure de l'état de charge d'un accumulateur Nickel-Cadmium consistant :

    - à décharger l'accumulateur Nickel-Cadmium à un courant de décharge I constant ;
    - à mesurer la partie imaginaire $Z_I$ de l'impédance complexe de l'accumulateur à une fréquence fixe en cours de décharge ;
    - à utiliser la partie imaginaire $Z_I$ mesurée en cours de décharge, ou encore une grandeur qui lui est proportionnelle, comme paramètre représentatif de l'état de charge de l'accumulateur ;

    caractérisé en ce que la grandeur utilisée comme paramètre représentatif de l'état de charge est calculée par la relation
    $$\Gamma = Z_I^{-2} f^{-3/2}$$
    dans laquelle f est ladite fréquence fixe et $Z_I$ est la partie imaginaire de l'impédance mesurée à ladite fréquence fixe en cours de décharge.

2. Procédé de mesure selon la revendication 1, caractérisé en ce que sa validité est assurée quelle que soit la capacité nominale ou la provenance commerciale de l'accumulateur Nickel-Cadmium par le réglage:

    - du courant de décharge I en fonction de la capacité nominale de l'accumulateur;
    - de la fréquence f du signal perturbateur en fonction de la capacité nominale et du courant de décharge;
    - de la valeur de la perturbation ΔI appliquée en fonction du courant de décharge I.

3. Dispositif permettant de mesurer l'état de charge d'un accumulateur Nickel-Cadmium, caractérisé en ce qu'il mesure l'impédance complexe de l'accumulateur (3') en cours de décharge, le dispositif comportant un circuit intensio-statique (2') qui permet de décharger l'accumulateur sous test à un courant de décharge I constant et à superposer à ce courant de décharge une composante alternative à une fréquence fixe, et comportant en plus un conditionneur de signaux (5') permettant de conditionner le signal aux bornes de l'accumulateur (3'), constitué d'une tension continue de l'accumulateur et d'une tension alternative, et le signal constitué du courant de décharge et du courant alternatif et qui est prélevé aux bornes d'une résistance étalon (4') en série avec l'accumulateur (3'), des échantillonneurs-bloqueurs (6') permettant d'échantillonner les signaux à la sortie du conditionneur (5'), un multiplexeur (7') permettant le multiplexage des signaux à la sortie des échantillonneurs-bloqueurs (6'), des convertisseurs analogiques-numériques (8') permettant la conversion en valeurs numériques des signaux à la sortie du multiplexeur (7') et des moyens de contrôle-commande (9') dont le programme est logé en mémoire (10') permettant le séquencement nécessaire des échantillonneurs-bloqueurs (6'), du multiplexeur (7'), et des convertisseurs analogiques-numériques (8'), le calcul de la partie imaginaire de l'impédance à partir des signaux numérisés et l'extraction de la valeur de l'état de charge conformément au procédé selon les revendications 1 et 2.

4. Dispositif selon la revendication 3, caractérisé en ce que le circuit intensiostatique (2') est remplacé par l'appareil utilisateur fonctionnant sur l'accumulateur, de telle sorte que le courant de décharge I est fixé par l'appareil utilisateur lui-même.

5. Dispositif selon la revendication 3, caractérisé en ce que les échantillonneurs-bloqueurs (6') et le multiplexeur (7') sont remplacés par un seul composant électronique permettant d'avoir une sortie proportionnelle à la partie imaginaire de l'impédance à partir des deux signaux d'entrée (tension et courant).

6. Dispositif selon la revendication 3 ou la revendication 5, caractérisé en ce que la partie contrôle commande (Bloc (C) ) est remplacée par un moyen de calcul et de contrôle externe convenablement programmé.

7. Dispositif selon l'une quelconque des revendications 3 à 6, caractérisé en ce que le moyen de calcul de l'état de charge est intégré à l'organe de contrôle-commande du système fonctionnant sur l'accumulateur.

**Patentansprüche**

1. Verfahren zur Messung des Ladezustandes einer Nickel-Cadmium Batterie bestehend aus:
   - dem Entladen der Nickel-Cadmium Batterie durch einen konstanten Entladestrom I;
   - dem Messen des imaginären Anteils $Z_I$ der komplexen Impedanz der Batterie im Laufe der Entladung bei einer festen Frequenz;
   - dem Gebrauch des im Laufe der Entladung gemessenen imaginären Anteils $Z_I$ oder wenigstens einer Größe, die diesem proportional ist, als repräsentativer Parameter des Ladezustandes der Batterie;
   **dadurch gekennzeichnet,**
   daß die als repräsentativer Parameter des Ladezustandes der Batterie gebrauchte Größe nach

der Gleichung

$$\Gamma = Z_I^{-2} f^{-3/2}$$

berechnet wird, in der f die genannte feste Frequenz und $Z_I$ der bei dieser genannten Frequenz im Laufe der Entladung gemessene imaginäre Anteil der Impedanz ist.

2. Verfahren zur Messung nach Anspruch 1, dadurch gekennzeichnet, daß seine Gültigkeit gesichert wird, welches auch die nominelle Kapazität oder die kommerzielle Herkunft der Nickel-Cadmium Batterie sei, durch Verstellung:
   - des Entladestromes I als Funktion der nominellen Kapazität der Batterie ;
   - der Frequenz f des Störsignals als Funktion der nominellen Kapazität und des Entladestromes;
   - des Wertes der Störung $\Delta I$, angewandt als Funktion des Entladestromes I.

3. Gerät, welches den Ladezustand einer Nickel-Cadmium Batterie zu messen erlaubt, **dadurch gekennzeichnet,** daß es die komplexe Impedanz der Batterie (3') im Laufe einer Entladung mißt, wobei das Gerät einen intensitätsstatischen Schaltkreis (2') umfaßt, der es erlaubt, die Batterie unter Test mit einem konstanten Ladestrom I zu entladen und diesem Entladestrom eine Wechselstromkomponente mit einer festen Frequenz zu überlagern, daß es zudem einen Signalformer (5') umfaßt, der es erlaubt, das Signal an den Anschlüssen der Batterie (3') zu formen, welches aus einer Gleichspannung der Batterie und einer Wechselspannung zusammengesetzt ist, und das Signal, welches aus dem Entladestrom und dem Wechselstrom zusammengesetzt ist und an den Anschlüssen eines Normalwiderstandes (4) abgegriffen wird, der in Reihe mit der Batterie geschaltet ist, zu formen, daß es Sampler (6') umfaßt, die es erlauben, die Signale am Ausgang des Signalformers zu sampeln, daß es einen Multiplexer (7') umfaßt, der eine Multiplexbearbeitung der Signale am Ausgang des Samplers (6') erlaubt, daß es Analog-Digital-Converter (8') umfaßt, die die Konversion der Signale am Ausgang des Multiplexers (7') in numerische Werte erlaubt, und daß es Kontroll-Steuer-Mittel (9') umfaßt, deren Programm in einem Speicher (10) untergebracht ist und die die notwendige Bearbeitungsfolge der Sampler (6'), des Multiplexers (7') und der Analog-Digital-Converter (8'), die Berechnung des imaginären Anteils der Impedanz aufgrund der digitalisierten Signale und die Extraktion des Wertes des Ladezustandes gemäß des Verfahrens nach den Ansprüchen 1 und 2 erlauben.

4. Gerät nach Anspruch 3, dadurch gekennzeichnet, daß der intensitätsstatische Schaltkreis (2') durch den Gebrauchsapparat, der mit der Batterie funktioniert, ersetzt ist, derart, daß der Entladestrom I durch den Gebrauchsapparat selbst festgelegt ist.

5. Gerät nach Anspruch 3, dadurch gekennzeichnet, daß die Sampler (6') und der Multiplexer (7') durch eine einzige elektronische Komponente ersetzt sind, die es erlaubt, ausgehend von zwei Eingangssignalen (Spannung und Strom) einen Ausgang proportional zum imaginären Anteil der Impedanz zu haben.

6. Gerät nach Anspruch 3 oder Anspruch 5, dadurch gekennzeichnet, daß der Kontroll-Steuer-Teil (Block(C)) durch ein angemessen programmierbares Rechner- und Kontroll-Mittel ersetzt ist.

7. Gerät nach einem der Ansprüche 3 bis 6, dadurch gekennzeichnet, daß das Mittel zur Errechnung des Ladezustandes im Kontroll-Steuer-Organ des mit der Batterie funktionierenden Systems integriert ist.

**Claims**

1. Method of measuring the state of charge of a nickel-cadmium battery, consisting of:
   - discharging the nickel-cadmium battery at a constant discharge current I;
   - measuring the imaginary part $Z_i$ of the complex impedance of the battery at a fixed frequency during the course of discharge;
   - using the imaginary part $Z_i$ measured in the course of discharge, or a quantity which is proportional thereto, as representative parameter of the state of charge of the battery;

   characterised in that the quantity used as representative parameter of the state of charge is calculated by the equation

   $$\Gamma = Z_i^{-2} f^{-3/2}$$

   in which f is the said fixed frequency and $Z_i$ is the imaginary part of the impedance measured at the said fixed frequency in the course of discharge.

2. Method of measuring as claimed in Claim 1, characterised in that its validity is ensured, whatever the nominal capacity or the commercial source of the nickel-cadmium battery may be, by the adjustment of:
   - the discharge current I as a function of the nominal capacity of the battery;
   - the frequency f of the interfering signal as a function of the nominal capacity and of the discharge current;
   - the value of the interference $\Delta I$ applied as a function of the discharge current I.

3. Device permitting measurement of the state of charge of a nickel-cadmium battery, characterised in that it measures the complex impedance of the battery (3') in the course of discharge, the device including an intensiostatic circuit (2') which enables the battery under test to be discharged at a constant discharge current I and enables this discharge current to be superimposed on an alternating component at a fixed frequency, and further including a signal conditioner (5') which permits conditioning of the signal at the terminals of the battery (3'), which consists of a direct current voltage from the battery and an alternating current voltage, and the signal consisting of the discharge current and the alternating current which is tapped at the terminals of a standard resistor (4') in series with the battery (3'), sampler-blockers (6') permitting sampling of the signals at the output of the conditioner (5'), a multiplexer (7') permitting multiplexing of the signals at the output of the sampler-blockers (6'), analogue-digital converters (8') permitting the conversion into digital values of the signals at the output of the multiplexer (7') and test and control means (9'), the programme of which is stored in a memory (10'), permitting the necessary sequencing of the sampler-blockers (6'), of the multiplexer (7') and of the analogue-digital converters (8'), the calculation of the imaginary part of the impedance from the digitised signals and the extraction of the value of the state of charge being carried out in accordance with the method as claimed in Claims 1 and 2.

4. Device as claimed in Claim 3, characterised in that the intensiostatic circuit (2') is replaced by the user apparatus functioning on the battery, in such a way that the discharge current I is fixed by the user apparatus itself.

5. Device as claimed in Claim 3, characterised in that the sampler-blockers (6') and the multiplexer (7') are replaced by one single electronic component which makes it possible to have an output proportional to the imaginary part of the impedance from the two input signals (voltage and current).

6. Device as claimed in Claim 3 or Claim 5, characterised in that the test and control part (block C) is replaced by a suitably programmed external calculation and test means.

7. Device as claimed in any one of Claims 3 to 6, characterised in that the means for calculating the state of charge is integrated into the test and control part of the system functioning on the battery.

FIGURE 1

FIGURE 2

FIGURE 3

8

FIGURE 4

FIGURE 5